# EUROPÄISCHE PATENTSCHRIFT

(11) **EP 3 582 596 B1**
(45) Veröffentlichungstag und Bekanntmachung des Hinweises auf die Patenterteilung: **12.08.2020**
(21) Anmeldenummer: 18178053.7
(22) Anmeldetag: 15.06.2018
(51) Int. Cl.: H05K 7/14

(54) **GEHÄUSE EINES ELEKTRONISCHEN GERÄTS**
CASE OF ELECTRONIC DEVICE
BOÎTIER D'UN APPAREIL ÉLECTRONIQUE

(43) Veröffentlichungstag der Anmeldung: 18.12.2019
(73) Patentinhaber: SICK AG, 79183 Waldkirch (DE)
(72) Erfinder: Saumer, Markus, 77948 Friesenheim (DE)

(56) Entgegenhaltungen:
- EP-A1- 0 579 859
- EP-A1- 3 331 334
- EP-A2- 0 896 504

## Beschreibung

Die Erfindung betrifft ein Gehäuse eines elektronischen Geräts gemäß dem Oberbegriff des Anspruchs 1.

In der heutigen Zeit werden elektronische Geräte überall im Alltag eingesetzt. Hierbei weisen die elektronischen Geräte, wie beispielsweise eine Sicherheitssteuerung, im Wesentlichen zumindest eine Leiterplatte auf, die in einem Gehäuse behaust ist. Das Gehäuse umfasst einen offenen Gehäuseabschnitt, aus dem die Leiterplatte mit elektrischen Kontakten hervorsteht. In dem offenen Gehäuseabschnitt ist ein Steckverbinder einsteckbar, so dass der Steckverbinder mit der Leiterplatte elektrisch verbunden ist. In dem Steckverbinder ist ein Gegensteckverbinder einsteckbar, so dass das elektronische Gerät mit anderen Geräten verbunden werden kann.

Solch ein Gehäuse ist beispielsweise aus DE 10 2011 110 184 A1 bekannt.

Das Gehäuse des elektronischen Geräts kann für unterschiedliche Gerätetypen eingesetzt werden, wobei die unterschiedlichen Gerätetypen unterschiedliche Leiterplatten aufweisen können. An den unterschiedlichen Leiterplatten können unterschiedliche Typen von Steckverbindern anschließbar sein, so dass ein Einstecken eines nicht für den Leiterplattentyp vorgesehenen Steckverbinders vermieden werden muss.

Hierzu sind die Steckverbinder des Standes der Technik mit einer Codierung versehen, so dass der Steckverbinder nur an eine Leiterplatte in einem Gehäuse mit einer entsprechenden Gegencodierung einsteckbar ist. Das heißt mit anderen Worten, die Codierung verhindert, dass ein Steckverbinder fälschlicherweise an eine Leiterplatte in einem Gehäuse eingesteckt wird, der nicht dem Typ der Leiterplatte entspricht.

Für die Codierung sorgt ein Codierungsmittel wie beispielsweise aus DE 20 2014 106 230 U1 bekannt. Hierbei besteht ein Nachteil, dass das Codierungsmittel separat beschafft werden muss, wobei das Codierungsmittel sehr klein ausgebildet und somit unhandlich ist und leicht verloren gehen kann.

EP 3 331 334 A1 offenbart ein Gehäuse mit den Merkmalen des Oberbegriffs des Anspruchs 1. Insbesondere weist das Gehäuse mit einem Rahmenmodul eine Schnittstellenaufnahme auf, in die ein austauschbares Schnittstellenmodul einsetzbar ist. Dieses Schnittstellenmodul weist wiederum einen Stift auf, auf den eine Mehrzahl an Codierungselementen beweglich aufgesteckt sind.

Es ist eine Aufgabe der Erfindung, ein Gehäuse der eingangs genannten Art derart zu verbessern, so dass ein Gehäuse mit sicherer Codierung einfach und preisgünstig herstellbar ist.

Die Aufgabe wird erfindungsgemäß durch ein Gehäuse eines elektrischen Geräts mit den Merkmalen des Anspruchs 1 gelöst.

Dies hat den Vorteil, dass keine zusätzliche Komponente beschafft werden muss. Ferner ist ein möglicher Verlust der Komponente mit der Codierung wie beim Stand der Technik ausgeschlossen. Weiterhin ergibt sich der Vorteil, dass der Codierungsstift nicht von alleine oder ohne größeren Kraftaufwand in die Nicht-Codierungsposition zurückgestellt werden kann. Der Codierungsstift ist damit in seiner Codierungsposition sicher gehalten.

Gemäß einem bevorzugten Ausführungsbeispiel ist der Codierungsstift reversibel von der Nicht-Codierungsposition in die Codierungsposition bringbar. Das heißt, eine Codierung des Gehäuses durch Stellen des Codierungsstifts in die Codierungsposition ist einfach rückgängig zu machen, wenn beispielweise eine falsche Codierung festgestellt wurde oder das Gehäuse für einen anderen Gerätetyp verwendet werden sollte. Hierdurch ist das Gehäuse mit dem Codierungsstift, insbesondere der Codierungsstift, wiederverwendbar.

Ferner ist gemäß einem bevorzugten Ausführungsbeispiel der Codierungsstift kippbar gelagert in dem offenen Gehäuseabschnitt angeordnet. Der Codierungsstift ist durch beispielsweise einen Schraubendreher einfach zwischen der Codierungsposition und der Nicht-Codierungsposition einstellbar, so dass ein Codierungsvorgang einfach durchführbar ist.

Weiterhin blockiert gemäß einem bevorzugten Ausführungsbeispiel der Codierungsstift in der Nicht-Codierungsposition ein Einstecken des Steckverbinders nicht und vorteilhafterweise blockiert der Codierungsstift in der Codierungsposition ein Einstecken des Steckverbinders, wenn kein entsprechendes Codierungsmittel am Steckverbinder entfernt ist.

Gemäß einem weiteren bevorzugten Ausführungsbeispiel ist eine Vielzahl an Codierungsstifte vorgesehen, und wobei die Codierungsstifte unabhängig voneinander individuell von der Nicht-Codierungsposition in die jeweilige Codierungsposition und vice versa bringbar sind. Hierdurch ist eine komplexe Codierung für das Gehäuse und dem entsprechenden Steckverbinder möglich.

Das erfindungsgemäße Gehäuse kann auf ähnliche Weise durch weitere Merkmale ausgestaltet werden und zeigt dabei ähnliche Vorteile. Derartige weitere Merkmale sind beispielhaft, aber nicht abschließend, in den sich an den unabhängigen Anspruch anschließenden Unteransprüchen beschrieben.

Die Erfindung wird nachstehend auch hinsichtlich weiterer Vorteile und Merkmale unter Bezugnahme auf die beigefügte Zeichnung anhand von Ausführungsbeispielen erläutert. Die Figuren der Zeichnung zeigen in:
- Fig. 1: eine schematische Perspektiv-Explosionsdarstellung eines erfindungsgemäßen Gehäuses,
- Fig. 2: eine Schnittansicht auf eine Schnittebene der Gerade A - A, und
- Fig. 3: eine perspektivische Detailansicht der erfindungsgemäßen Codierungsstifte in einer Codierungsposition.

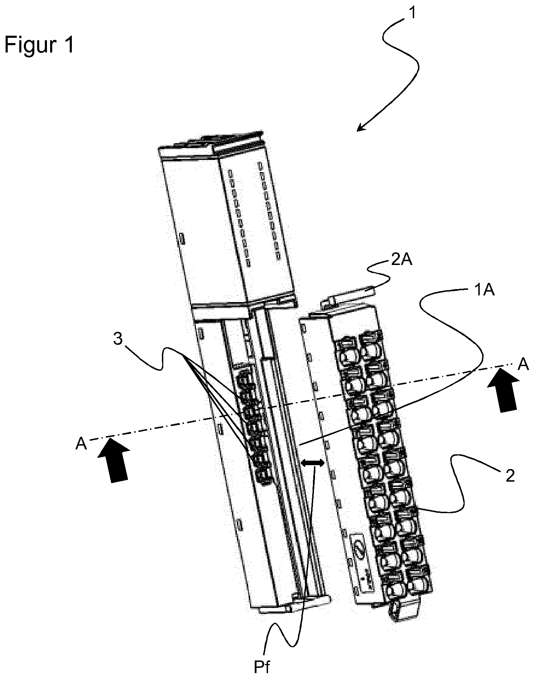

Figur 1 zeigt eine schematische Perspektiv-Explosionsdarstellung eines erfindungsgemäßen Gehäuses 1 eines elektronischen Geräts, wobei das elektronische Gerät beispielsweise eine Sicherheitssteuerung oder dergleichen sein kann.

Das Gehäuse 1 umfasst zumindest eine nicht dargestellte Leiterplatte, die in dem Gehäuse 1 behaust ist, und einen offenen Gehäuseabschnitt 1A. In dem offenen Gehäuseabschnitt 1A ist ein Steckverbinder 2 mittels einer Schwenkbewegung einsteckbar, indem der Steckverbinder 2 entlang des angezeigten Pfeiles Pf bis zu einem Einrasten der Verbindungslasche 2A in dem offenen Gehäuseabschnitt 1A geführt wird. Der Steckverbinder 2 ist in der eingesteckten Position in dem offenen Gehäuseabschnitt 1A mit der Leiterplatte elektrisch verbunden.

In dem Steckverbinder 2 ist ein nicht dargestellter Gegensteckverbinder oder auch einzelne Gegenstecker einsteckbar, so dass das elektronische Gerät mit dem Gehäuse 1 mit anderen elektronischen Geräten verbunden ist. Der Steckverbinder 2 kann vorzugsweise auch Federzugklemmen zum direkten Anschließen von Leitungen umfassen, so dass die Leitungen der anderen elektronischen Geräte mittels der Federzugklemmen mit dem Steckverbinder 2 direkt angeschlossen werden können.

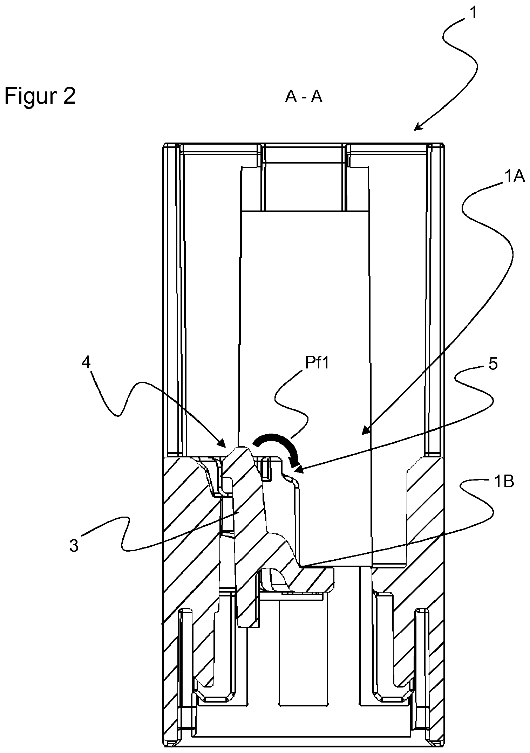

Das erfindungsgemäße Gehäuse 1 umfasst mindestens einen Codierungsstift 3, der in dem offenen Gehäuseabschnitt 1A integriert verarbeitet ist, wobei der Codierungsstift 3 von einer Nicht-Codierungsposition 4 in eine Codierungsposition 5, wie in der Figur 2 angedeutet, bringbar ist. Mit anderen Worten, der Codierungsstift 3 ist einstückig mit dem Gehäuse 1 hergestellt, wobei der Codierungsstift 3 bewegbar ist. Hierbei ist der Codierungsstift 3 kippbar in dem offenen Gehäuseabschnitt 1A gelagert. Vorteilhafterweise ist das Gehäuse 1 zusammen mit dem Gehäuseabschnitt 1A und dem zumindest einen Codierungsstift 3 mittels Spritztechnik hergestellt.

Hierbei ist der Codierungsstift 3 reversibel von der Nicht-Codierungsposition in die Codierungsposition bringbar. Das heißt, der Codierungsstift 3 ist beliebig entsprechend einer benötigten Codierung von der Nicht-Codierungsposition in die Codierungsposition und vice versa bringbar, so dass der Codierungsstift 3 nicht als "Einwegteil" zu nutzen ist.

In der Figur 2 ist eine Schnittansicht des Gehäuses 1 entlang der Linie A - A durch einen Codierungsstift 3 dargestellt, aus der zu erkennen ist, dass sich der Codierungsstift 3 in der Nicht-Codierungsposition 4 befindet. Der Codierungsstifte 3 ist in Richtung des Pfeils Pf1 von der Nicht-Codierungsposition 4 in die Codierungsposition 5 kippbar. Durch die integrierte Verarbeitung des Codierungsstifts 3 mit einer Innenkante 1B des offenen Gehäuseabschnittes 1A ist das Kippen des Codierungsstiftes 3 zwischen der Nicht-Codierungsposition 4 und der Codierungsposition 5 und vice versa möglich. Hierbei ist jeder Codierungsstift 3 unabhängig voneinander individuell in die jeweilige Codierungsposition bringbar. Hierdurch ist eine Vielzahl an komplexe Codierungen für jeweilige aufsteckbare Steckverbinder 2 möglich.

In der dargestellten Nicht-Codierungsposition der Codierungsstifte 3 blockiert der Codierungsstift 3 ein Einstecken des Steckverbinders 2 nicht. Ist jedoch eines der Codierungsstifte 3 in die Codierungsposition gebracht, so blockiert der Codierungsstift 3 in der Codierungsposition ein Einstecken des Steckverbinders 2, wenn kein entsprechendes Codierungsmittel am Steckverbinder 2 vorher entfernt ist. Das Codierungsmittel am Steckverbinder 2 kann ein Sperrblättchen, eine Rippe oder ähnliches sein, wobei das entsprechende Codierungsmittel vor dem Einstecken zu entfernen ist.

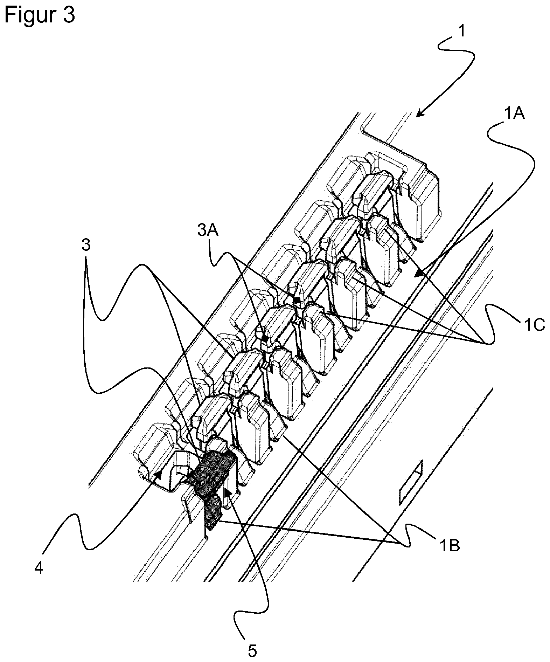

Wie die perspektivische Detailansicht des Codierungsstifts 3 in der Figur 3 zeigt, weist der Codierungsstift 3 vorzugsweise einen ersten Absatz 3A auf, der seitlich am Codierungsstift 3 angeordnet ist. In dem Ausführungsbeispiel, wie in der Figur 3 gezeigt, weist der Codierungsstift 3 seitlich auf beiden Seiten jeweils einen ersten Absatz 3A auf. Der erste Absatz 3A ist vorgesehen, um in einem Vorsprung 1C am offenen Gehäuseabschnitt 1A einzugreifen, wenn sich der Codierungsstift 3 in der Codierungsposition 5 befindet. Das heißt, wenn der geschwärzte Codierungsstift 3 in die Codierungsposition 5 gekippt ist, rasten die beiden ersten Absätze 3A in die jeweiligen entsprechenden Vorsprünge 1C am offenen Gehäuseabschnitt 1A ein, so dass der Codierungsstift 3 nicht ohne Weiteres wieder in die Nicht-Codierungsposition 4 zurückkippen kann. Um den Codierungsstift 3 wieder in die Nicht-Codierungsposition 4 zurückzustellen, muss ein Widerstand der ersten Absätze 3A entgegen einer Richtung zu der Nicht-Codierungsposition 4 überwunden werden. Dadurch kann der Codierungsstift 3 nicht durch einen nicht entsprechend codierten Steckverbinder 2, auch mit stärkerem Drücken des Steckverbinders 2 in den offenen Gehäuseabschnitt 1A, in die Nicht-Codierungsposition 4 zurückgestellt werden.

Da der Codierungsstift 3 über die Innenkante 1B des offenen Gehäuseabschnittes 1A mit dem Gehäuse 1 verbunden ist, verformt sich das Material an dieser Innenkante 1B, so dass der Codierungsstift 3 in Richtung der Nicht-Codierungsposition 4 unter Druck steht. Dies bedeutet wiederum, dass der Codierungsstift 3 nicht von alleine bzw. versehentlich von der Nicht-Codierungsposition 4 in die Codierungsposition 5 kippen kann, da insbesondere der genannte Materialdruck durch die Materialverformung überwunden werden muss.

Hierbei bleibt der Codierungsstift 3 weiterhin bewegbar, so dass der Codierungsstift 3 je nach Bedarf einer Codierung bzw. einer geänderten Codierung mittels eines geeigneten Werkzeugs zurück in die Nicht-Codierungsposition 4 gestellt werden kann. Das Gehäuse 1 mit dem Codierungsstift 3 bzw. den Codierungsstiften 3 ist somit mit völlig unterschiedlichen Typen von Steckverbindern 2 verwendbar, ohne dass zusätzliche Komponenten beschafft und verbaut werden müssen.

### Bezugszeichenliste

- 1: Gehäuse
- 1A: Offener Gehäuseabschnitt
- 1B: Innenkante des Gehäuseabschnittes
- 1C: Vorsprung
- 2: Steckverbinder
- 2A: Verbindungslasche
- 3: Codierungsstift
- 3A: Erster Absatz
- 3B: Zweiter Absatz
- 4: Nicht-Codierungsposition
- 5: Codierungsposition
- A - A: Schnittlinie
- Pf: Pfeil

## Patentansprüche

1. Gehäuse (1) eines elektronischen Geräts, umfassend
einen offenen Gehäuseabschnitt (1A), in dem ein Steckverbinder (2) einsteckbar ist, und
mindestens einen Codierungsstift (3), wobei der Codierungsstift (3) von einer Nicht-Codierungsposition (4) in eine Codierungsposition (5) und umgekehrt bringbar ist, **gekennzeichnet durch**
zumindest eine Leiterplatte, die in dem Gehäuse (1) behaust ist und mit dem Steckverbinder (2) elektrisch verbindbar ist,
wobei der Codierungsstift (3) einen ersten Absatz (3A) aufweist, der seitlich am Codierungsstift (3) angeordnet ist, und der erste Absatz (3A) in einen Vorsprung (1B) am offenen Gehäuseabschnitt (1A) eingreift, wenn sich der Codierungsstift (3) in der Codierungsposition (5) befindet, und
wobei das Gehäuse (1) zusammen mit dem offenen Gehäuseabschnitt (1A) und dem mindestens einen Codierungsstift (3) mittels Spritztechnik einteilig hergestellt ist, so dass der zumindest eine Codierungsstift (3) in dem offenen Gehäuseabschnitt (1A) integriert ist.

2. Gehäuse (1) nach Anspruch 1, **dadurch gekennzeichnet, dass** der Codierungsstift (3) reversibel von der Nicht-Codierungsposition (4) in die Codierungsposition (5) bringbar ist.

3. Gehäuse (1) nach Anspruch 1 oder 2, **dadurch gekennzeichnet, dass** der Codierungsstift (3) kippbar gelagert in dem offenen Gehäuseabschnitt (1A) angeordnet ist.

4. Gehäuse (1) nach einem der vorhergehenden Ansprüche 1 bis 3, **dadurch gekennzeichnet, dass** in der Nicht-Codierungsposition (4) der Codierungsstift (3) ein Einstecken des Steckverbinders (2) nicht blockiert.

5. Gehäuse (1) nach einem der vorhergehenden Ansprüche 1 bis 4, **dadurch gekennzeichnet, dass** in der Codierungsposition (5) der Codierungsstift (3) ein Einstecken des Steckverbinders (2) blockiert, wenn kein entsprechendes Codierungsmittel am Steckverbinder (2) entfernt ist.

6. Gehäuse (1) nach einem der vorhergehenden Ansprüche 1 bis 5, **dadurch gekennzeichnet, dass** eine Vielzahl an Codierungsstiften (3) vorgesehen ist, und wobei die Codierungsstifte (3) unabhängig voneinander individuell von der Nicht-Codierungsposition (4) in die jeweilige Codierungsposition (5) und vice versa bringbar sind.

## Claims

1. Housing (1) of an electronic device comprising
an open housing portion (1A) into which a plug connector (2) is insertable, and at least one coding pin (3), wherein the coding pin (3) can be brought from a non-coding position (4) into a coding position (5) and vice versa, **characterised by** at least one printed circuit board housed in the housing (1) and electrically connectable to the connector (2),
wherein the code pin (3) has a first shoulder (3A) disposed laterally on the code pin (3), and the first shoulder (3A) engages a projection (1B) on the open housing portion (1A) when the code pin (3) is in the coding position (5), and
wherein the housing (1) together with the open housing portion (1A) and the at least one coding pin (3) is manufactured in one piece by means of injection molding so that the at least one coding pin (3) is integrated in the open housing portion (1A).

2. Housing (1) according to claim 1, **characterized in that** the coding pin (3) can be reversibly brought from the non-coding position (4) into the coding position (5).

3. Housing (1) according to claim 1 or 2, **characterized in that** the coding pin (3) is tiltably mounted in the open housing portion (1A).

4. Housing (1) according to one of the preceding claims 1 to 3, **characterized in that** in the non-coding position (4) the coding pin (3) does not block insertion of the connector (2).

5. Housing (1) according to one of the preceding claims 1 to 4, **characterized in that** in the coding position (5) the coding pin (3) blocks insertion of the plug connector (2) if no corresponding coding means is removed from the plug connector (2).

6. Housing (1) according to any of the preceding claims 1 to 5, **characterized in that** a plurality of coding pins (3) is provided, and wherein the coding pins (3) can be brought individually and independently of one another from the non-coding position (4) to the respective coding position (5) and vice versa.

## Revendications

1. Boîtier (1) d'un dispositif électronique comprenant
une partie de boîtier ouverte (1A) dans laquelle un connecteur (2) peut être insérer, et
au moins une broche de codage (3), dans laquelle la broche de codage (3) peut être amenée d'une position de non-codage (4) à une position de codage (5) et vice versa, **caractérisé par**
au moins une carte de circuit imprimé logée dans le boîtier (1) et pouvant être connectée électriquement au connecteur (2),
la broche de codage (3) ayant un premier épaulement (3A) qui est disposé latéralement sur la broche de codage (3), et le premier épaulement (3A) engageant une saillie (1B) sur la partie ouverte du boîtier (1A) lorsque la broche de codage (3) est dans la position de codage (5), et
dans lequel le boîtier (1) ainsi que la partie ouverte du boîtier (1A) et au moins une broche de codage (3) sont fabriqués en une seule pièce par moulage par injection, de sorte que la ou les broches de codage (3) sont intégrées dans la partie ouverte du boîtier (1A).

2. Boîtier (1) selon la revendication 1, **caractérisé en ce que** la broche de codage (3) peut être amenée de manière réversible de la position de non-codage (4) à la position de codage (5).

3. Boîtier (1) selon la revendication 1 ou 2, **caractérisé en ce que** la broche de codage (3) est montée de manière basculante dans la partie ouverte du boîtier (1A).

4. Boîtier (1) selon l'une des revendications précédentes 1 à 3, **caractérisé en ce que** dans la position de non-codage (4), la broche de codage (3) ne bloque pas l'insertion du connecteur (2).

5. Boîtier (1) selon l'une des revendications précédentes 1 à 4, **caractérisé en ce que** dans la position de codage (5), la broche de codage (3) bloque l'insertion du connecteur (2) si aucun moyen de codage correspondant n'est retiré du connecteur (2).

6. Boîtier (1) selon l'une des revendications précédentes 1 à 5, **caractérisé en ce qu'il** est prévu une pluralité de broches de codage (3), et dans lequel les broches de codage (3) peuvent être amenées individuellement et indépendamment de la position de non-codage (4) à la position de codage respective (5) et vice versa.
